# EUROPEAN PATENT APPLICATION

(11) **EP 1 510 950 A2**
(43) Date of publication of application: **02.03.2005**
(21) Application number: 04104132.8
(22) Date of filing: 27.08.2004
(51) Int. Cl.: G06F 17/50

(54) **A method for finding maximum volume and minimum cut in a network of interconnected nodes**

(30) Priority: 29.08.2003 IN DE20031073
(71) Applicant: STMicroelectronics Pvt. Ltd., 201 302 Uttar Pradesh (IN)
(72) Inventor: Sharma, Sunil Kumar, 201301 Noida UP (IN); Tomar, Ajay, 201301 Noida UP (IN); Samanta, Dhabalendu, 110 091 Delhi (IN)
(74) Representative: Pezzoli, Ennio

(57) **Abstract**

An improved method for finding a maximum volume minimum cutset in a network of interconnected nodes, applicable to any system that can be reduced to such network including telecommunication network, traffic network, computer networks, layouts, hydraulic networks etc. According to the invention an equivalent network is derived by replacing all nodes other then source and sink by two interconnected nodes, a conventional method applying augmenting path algorithm identifies then a cutset. If the feasible cutset is not achieved than a reduced network is constructed by directly connecting the member nodes of identified cutset to the source node and repeating the above process for the reduce network until a feasible cutset is achieved.

## Description

### Field of the Invention

The present invention relates to an improved method for fmding maximum volume and minimum cut in a network of interconnected nodes, more particularly the invention relates to optimally packing the nodes in an LUT while insuring minimum delay.

### Background of the invention

The invention described below is applicable to any network of interconnected nodes and is applicable to any system including telecommunication systems, traffic system, computer networks, layouts, hydraulic systems etc. that can be reduced to a network of interconnected nodes.

The invention is being described herein with respect to an example that is applicable to PLAs.

A digital circuit consist of basic electronic circuits forming different digital component including logic gates, registers etc. These digital components are interconnected to provide a circuit that operates in a desired fashion. A Programmable Logic Array (PLA) has a plurality of such digital circuits that are mapped over logic elements to form an efficient and flexible device. An important objective during mapping of an electrical circuit over a PLA is, to map maximum number of circuit elements over a single logic element and to achieve a smallest possible network of logic elements to realize the electrical circuit while insuring the minimum possible delay.

For mapping a digital circuit on a logic element the said digital circuit is converted into a network of plurality of interconnected nodes having termination nodes named source (s) and sink (t), where the nodes represent a generalised digital component of the digital circuit. Two nodes are interconnected by at least an edge; each edge is assigned a capacity Cᵢⱼ that represents the amount of flow through the edge, here the capacity Cᵢⱼ represent capacity of edge connecting i^{th} node to j^{th} node.

Further a residual network can be produced by introducing residual edge between two interconnected nodes in the original network. The residual capacity of the residual edge can then be defined as an amount of additional net flow that can be pushed across two nodes without exceeding the capacity Cᵢⱼ of the edge connecting these nodes in the original network. The said network is then mapped over the logic element using a logic algorithm.

Augmenting path algorithm is one of the commonly used algorithms to find all distinct paths in the network. According to the algorithm an augmented path is a directed path from the source to the sink in the residual network such that every arc on this path has strictly positive residual capacity. The minimum of these residual capacities is called the residual capacity of the augmenting path because it represents the amount of flow that can feasibly be added to the entire path. A mathematical derivation, proof and examples of the augmenting path algorithm are available in general textbooks / research papers relating to the subject matter.

Various technologies propose different methods for mapping a digital circuit on a logic element. For example a polynomial time technology mapping algorithm has been proposed by K. C. Chen, J. Cong, Y. Ding et. al. [3] in which a Flow-Map that optimally maps electrical circuit on FPGA for depth minimization by computing a minimum height for k-feasible cut a network. This algorithm is commonly used for technology mapping.

In another research article by J. Cong et. al. [4] have suggested an algorithm for FPGA mapping technology. In this technique a number of depth relaxation operation are performed to obtain a new network with bounded increase in depth and advantageous to subsequent re-mapping for area minimization by gradually increasing depth bound.

An integrated approach for synthesizing and mapping has been disclosed by Francis, et. al. [5]. This algorithm uses global combinatorial optimization techniques to guide the Boolean synthesis process during depth minimization. The combinatorial optimization is achieved by computing series of minimum cuts of fixed heights in a network based on fast network computation and the Boolean optimization is achieved by efficient Ordered Binary Decision Diagrams (OBDD) based implementation of functional decomposition.

Further in an approach by Francis, R. J., J. Rose et. al. [6], a new algorithm has been discussed for technology mapping in which the method for choosing gate level decompositions based on bin packing is innovative.

Several other approaches have also been applied to achieve these objectives. However, all the methods mention above and many others either map in minimum number of logic elements or minimize delay of mapped circuit. There is no method that maps a design such that delay of the mapped circuit is minimum and the area is minimum under the said delay.

Thus it has been observed that there is a need to develop a technique that provides a method and device for packing maximum nodes in a single logic element ensuring minimum delay.

### Summary of the invention

The object of the invention is to overcome the above and other drawbacks of the prior art and provide a method for identifying the maximum volume, minimum cutset of the original network in a reliable and consistent manner.

To achieve said objective, the present invention provides a method as set out in the independent claims.

Particularly, an aspect of the invention proposes an improved method for finding a maximum volume minimum cutset in a network of interconnected nodes having a source node and at least one sink node, comprising the steps of:
a. constructing a derived network for a given sink by replacing all nodes other than the source and sink by a set of first and second interconnected nodes connected by a single bridging edge such that the bridging edge connects the output of first node to the input of second node, the said first node receiving the inputs from previous nodes of network, and the second node providing the outputs to the next nodes of the network;
b. assigning to each bridging edge a capacity of unity and to each non-bridging edge a capacity of infinity;
c. applying the augmenting path algorithm to identify all the distinct paths from the source node to a sink node;
d. identifying a member of maximum volume minimum cutset as the first saturated node encountered while traversing from the source to sink
e. discarding those member nodes that have all the output nodes as members of said set;
f. checking if the feasible cut set is not achieved then:
   i. constructing a reduced network by connecting the member of the said cut set to the source directly;
   ii. repeating the steps c-f for the reduced network;
g. repeating steps a-f for each sink of the said network.

Another aspect of the invention proposes an improved method for optimally mapping a digital logic circuit over minimum number of Look-Up-Table (LUTs) in a programmable logic device while minimising signal delay comprising the steps of:
a. constructing a network of interconnected nodes, each node depicting one or more circuit element of the said digital logic circuit;
b. constructing a derived network for a given sink by replacing all nodes other than the source and sink by a set of first and second interconnected nodes connected by a single bridging edge such that the bridging edge connects the output of first node to the input of second node, the said first node receiving the inputs from previous nodes of network, and the second node providing the outputs to the next nodes of the network;
c. assigning to each bridging edge a capacity of unity and to each non-bridging edge a capacity of infinity;
d. applying the augmenting path algorithm to identify all the distinct paths from the source node to a sink node;
e. identifying a member of maximum volume minimum cutset as the first saturated node encountered while traversing from the source to sink
f. discarding those member nodes that have all the output nodes as members of said set;
g. checking if the feasible cut set is not achieved then;
   i. constructing a reduced network by connecting the member of the said cut set to the source directly;
   ii. repeating the steps k-n for the reduced network;
h. repeating steps i-o for each sink of the said network.

The novel features believed to be characteristic of this invention are set forth in the appended claims. The invention itself, however, as well as these and other related objects and advantages thereof, will be best understood by reference to the following detailed description to be read in conjunction with the accompanying drawings.

### Brief Description of the Drawings

**Figure 1** shows a network of interconnected nodes.
**Figure 2** shows a derived network of interconnected nodes.
**Figure 3** shows a reduced network of interconnected nodes in accordance with the present invention.

### Detailed description of the preferred embodiment(s) of the invention

A person skilled in the art will appreciate that the following description of present invention is illustrative only and is applicable to variety of programmable logic arrays having logic elements/Look Up Tables (LUTs) of different sizes and is no way limiting to the discussed embodiment/s only. Any such application of the invention will fall under the scope of the invention. Any application of the invention to other systems for which a networking problem can be reduced to a network of interconnected nodes of will also fall under the scope of the invention.

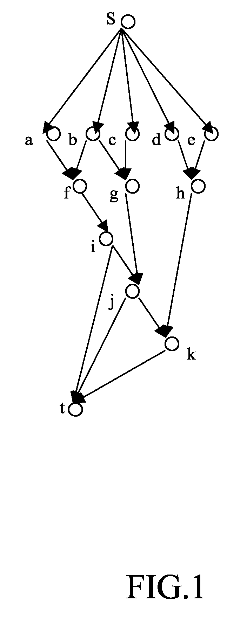

**Figure 1** shows a network of interconnected nodes having source **s** and the sink **t**. The source s provides input to other intermediate nodes a, b, c, d, e that further connects the other intermediate nodes and the sink as shown.

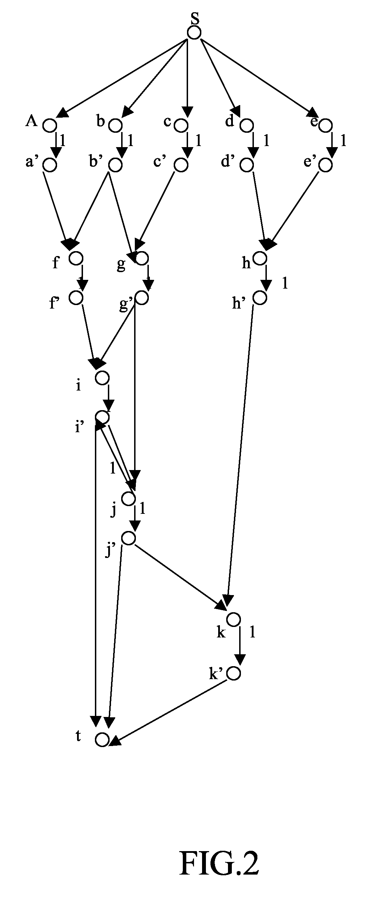

**Figure 2** shows a derived network of interconnected nodes from the network of **figure 1**. The said derived network is obtained by replacing each intermediate node **v** by two nodes **v, v'** and connecting the nodes **v, v'** by an edge **(v, v')** referred as bridging edge of capacity 1 and assigning capacity infinity to rest of the edges. For the serially connected intermediate nodes **u, v** and **w** of original network the connection in derived network is such that the edge **(u, v)** is transformed into the edge **(u', v)** and the edge **(v, w)** transforms into **(v', w)**.

All the possible distinct paths in the said derived network by applying augmenting path algorithm are found. Then a set of nodes providing a minimum cut is recognized by cut finding algorithm. The cut finding algorithm identifies a member of said set as the first saturated node encountered while traversing from the source **s** to sink **t**. Further if the all output nodes of any member node of said set are also the member of said set then such node is discarded from the said set.

In the present example of **figure 2** following distinct paths are identified using augmenting path algorithm:
P1=(s,a,a',f,f',t),
P2 = (s, b, b', g, g', j, j', t),
P3 = (s, d, d', h, h', k, k', t).

For these three distinct paths a set of nodes providing minimum cut can be determined using cut finding algorithm as **{a, b, g, h}**, which is not three feasible.

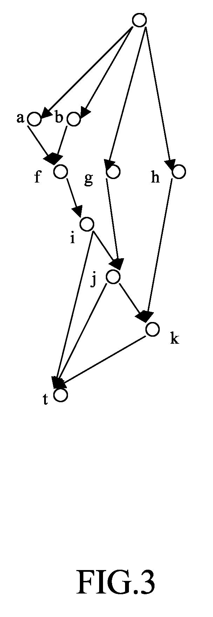

In order to reduce the said set to a three feasible set insuring maximum volume and minimum delay, the present invention provides following:
- Step 1: A reduced network is constructed by connecting the nodes of the set-providing minimum cut directly to the source s; (as shown in **figure 3**)
- Step 2: Applying the augmenting path algorithm and cut finding algorithm to the said reduced network for determine a new set of node providing minimum cut;
- Step 3: Applying steps 1 and step 2 until a three feasible cut is found.

The example of **figure 2** to on applying above algorithm provides a cut set **{f, g, h},** which is in fact the best cut set for the network as evident from the figure.

Following is the table that compares results obtain for LUT mapping using the conventional method and the instant invention.

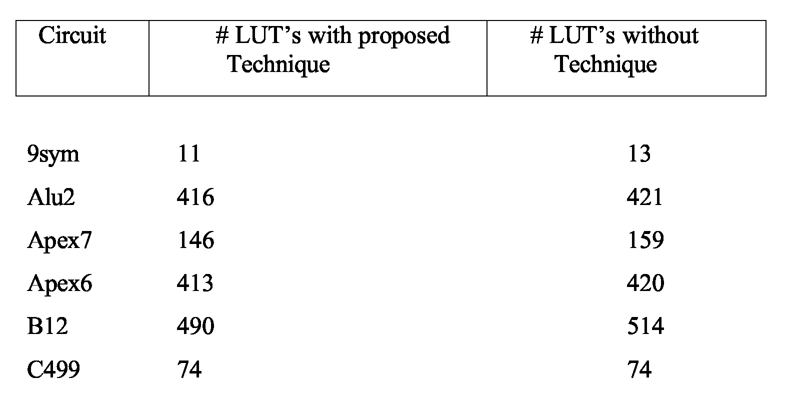

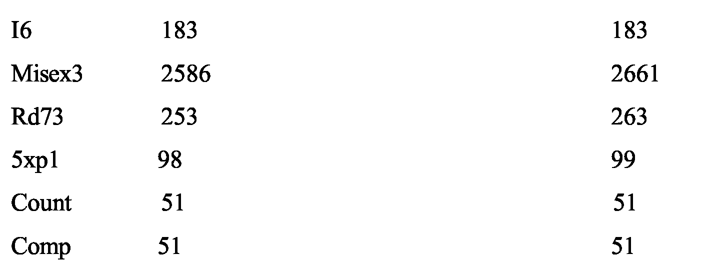

Further the invention can also be realized for the networks with more then one sinks t¹, t²... etc. by replicating separately the mapping for each sink to a different logic element.

Furthermore the cuts determined by this method can also be used for solving networking problems related to the system likes telecommunication systems, traffic system, computer networks, layouts, hydraulic systems etc.

Naturally, in order to satisfy local and specific requirements, a person skilled in the art may apply to the solution described above many modifications and alterations all of which, however, are included within the scope of protection of the invention as defined by the following claims.

### References:

1. R. J. Francis, J. Rose, and Z. Vranesic, "Technology mapping of lookup table-based FPGAs for performance," in *IEEE*/*ACM International Conference on Computer- Aided Design (ICCAD), pp. 568-571, 1991.*
2. K.-C. Chen, J. Cong, Y. Ding, A. B. Kahng, and P. Trajmar, "DAG-Map: Graph based FPGA technology mapping for delay optimization," *IEEE Design & Test of Computers, pp. 7-20, Sept. 1992.*
3. K.-C. Chen, J. Cong, Y. Ding, "Flow-map: An optimal technology mapping algorithm for delay optimization in lookup-table based FPGA designs," *IEEE Transactions on Computer-Aided Design of Integrated Circuits and Systems CAD, vol. 13, pp. 1-12, Jan. 1994.*
4. J. Cong and Y. Ding, "On area/depth trade-off in LUT-based FPGA technology mapping," in *30th ACM*/*IEEE Design Automation Conference (DAC), pp. 213-218, 1993.*
5. J. Cong and Y. Ding, "Beyond the combinatorial limit in depth minimization for LUT-based FPGA designs," in *IEEE*/*ACM International Conference on Computer-Aided Design (ICCAD), pp. 110-114,Nov. 1993.*
6. Francis, R. J., J. Rose, and K. Chung, "Chortle: A Technology Mapping Program for Lookup Table-Based Field Programmable Gate Arrays," *Proc. 27th ACM*/*IEEE Design Automation Conference, pp. 613-619, June 1990.*
7. Sundarajarao Mohan, Kamal Chaudhary, " Delay Optimized Mapping for Programmable Gate Arrays with Multiple sized Lookup Tables", *Xilinx Inc, Patent No. US 6,336,208 B1, DateofPatentJan. 1, 2002*

## Claims

1. An improved method for finding a maximum volume minimum cutset in a network of interconnected nodes having a source node and at least one sink node, comprising the steps of:
a. constructing a derived network for a given sink by replacing all nodes other than the source and sink by a set of first and second interconnected nodes connected by a single bridging edge such that the bridging edge connects the output of first node to the input of second node, the said first node receiving the inputs from previous nodes of network, and the second node providing the outputs to the next nodes of the network;
b. assigning to each bridging edge a capacity of unity and to each non-bridging edge a capacity of infinity;
c. applying the augmenting path algorithm to identify all the distinct paths from the source node to a sink node;
d. identifying a member of maximum volume minimum cutset as the first saturated node encountered while traversing from the source to sink
e. discarding those member nodes that have all the output nodes as members of said set;
f. checking if the feasible cut set is not achieved then:
i. constructing a reduced network by connecting the member of the said cut set to the source directly;
ii. repeating the steps c-f for the reduced network;
g. repeating steps a-f for each sink of the said network.

2. An improved method for optimally mapping a digital logic circuit over minimum number of Look-Up-Table (LUTs) in a programmable logic device while minimising signal delay comprising the steps of:
a. constructing a network of interconnected nodes, each node depicting one or more circuit element of the said digital logic circuit;
b. constructing a derived network for a given sink by replacing all nodes other than the source and sink by a set of first and second interconnected nodes connected by a single bridging edge such that the bridging edge connects the output of first node to the input of second node, the said first node receiving the inputs from previous nodes of network, and the second node providing the outputs to the next nodes of the network;
c. assigning to each bridging edge a capacity of unity and to each non-bridging edge a capacity of infinity;
d. applying the augmenting path algorithm to identify all the distinct paths from the source node to a sink node;
e. identifying a member of maximum volume minimum cutset as the first saturated node encountered while traversing from the source to sink
f. discarding those member nodes that have all the output nodes as members of said set;
g. checking if the feasible cut set is not achieved then;
i. constructing a reduced network by connecting the member of the said cut set to the source directly;
ii. repeating the steps k-n for the reduced network;
h. repeating steps i-o for each sink of the said network.
